# EUROPÄISCHE PATENTSCHRIFT

(11) **EP 1 051 783 B1**
(45) Veröffentlichungstag und Bekanntmachung des Hinweises auf die Patenterteilung: **09.01.2002**
(21) Anmeldenummer: 99908755.4
(22) Anmeldetag: 29.01.1999
(51) Int. Cl.: H01S 5/32

(54) **HALBLEITERLASER-CHIP**
SEMICONDUCTOR LASER CHIP
PUCE DE LASER A SEMI-CONDUCTEUR

(30) Priorität: 30.01.1998 DE 19803759
(43) Veröffentlichungstag der Anmeldung: 15.11.2000
(73) Patentinhaber: Osram Opto Semiconductors GmbH & Co. OHG, 93049 Regensburg (DE)
(72) Erfinder: EBELING, Karl, Joachim, D-89075 Ulm (DE)
(74) Vertreter: Epping, Wilhelm, Dipl.-Ing.
(86) Internationale Anmeldenummer: DE9900240
(87) Internationale Veröffentlichungsnummer: WO9939405

(56) Entgegenhaltungen:
- EP-A1- 0 076 761
- EP-A2- 0 663 710
- US-A- 5 252 839
- US-A- 5 636 234

## Beschreibung

Die Erfindung bezieht sich auf einen Halbleiterlaser-Chip, bei dem in einem optischen Resonator eine laseraktive Halbleiterstruktur angeordnet ist.

Derartige Laserlaser-Chips sind beispielsweise aus den Druckschriften US 5,016,252, JP-OS 2-71574 und JP-OS 61-247084 bekannt. Hierin sind Laserdiodenchips beschrieben, bei denen eine n-leitende Deckschicht, eine aktive Schicht und eine p-leitende Deckschicht nacheinander auf einem Halbleitersubstrat aufgebracht sind. Die Druckschrift EP-A-0 076 761 offenbart einen Halbleiter laser, der neben dem laseraktiven pn-Übergang einen weiteren, dem laseraktiven Übergang entgegengerichteten pn-Übergang umfaßt. Dieser weitere pn-Übergang dient der strombegrenzung und ist nicht laseraktiv.

Halbleiterlaser-Chips diesere Art gibt es in den Materialsystemen InAlGaAs oder InAlGaP auf GaAs-Substrat, InAlGaAsP auf InP-Substrat oder InAlGaN auf Saphir- oder SiC-Substrat als Kantenemitter und Vertikalemitter, songenannten Vertical Cavity Surface Emitting Laser (VCSEL).

Die Aufgabe der vorliegenden Erfindung besteht darin, einen Halbleiterlaser-Chip zu entwickeln, der eine gegenüber dem Stand der Technik erhöhte Effizienz und eine erhöhte Ausgangsleistung aufweist.

Diese Aufgabe wird durch Halbleiterlaser-Chips mit den Merkmalen des Anspruches 1 oder des Anspruches 2 gelöst.

Erfindungsgemäß werden in ein und denselben Resonator des Halbleiterlaser-Chips zwei oder mehrere in Serie geschaltete laseraktive pn-Übergänge eingebracht, deren Vorwärtsrichtungen gleichgerichtet sind. Die laseraktiven pn-Übergänge enthalten an sich bekannte Quantenwells für die Ladungsträgerrekombination. Zwischen zwei laseraktiven pn-Übergänge ist jeweils ein pn-Übergang angeordnet, dessen Vorwärtsrichtung der Vorwärtsrichtung der laseraktiven pn-Übergänge entgegengerichtet ist, der also gegenüber der Vorwärtsrichtung des Halbleiterlaser-Chips rückwärtsgepolt ist. Der oder die rückwärtsgepolten pn-Übergänge befinden sich in Halbleitermaterial mit einem größeren Bandabstand als das Halbleitermaterial der laseraktiven pn-Übergänge.

Bei einem kantenemittierenden Halbleiterlaser-Chip befinden sich die laseraktiven pn-Übergänge in einer wellenführenden Zone. Bei vertikal emittierenden Halbleiterlaser-Chips (VCSELs) liegen die Quantenwells der laseraktiven pn-Übergänge in den Bäuchen und der rückwärtsgepolte pn-Übergang bzw. die rückwärtsgepolten pn-Übergänge im bzw. in den Knoten des in dem Halbleiterlaser-Chip erzeugten Stehwellenfeldes.

Vorteilhafterweise beträgt der Abstand zwischen zwei aufeindanderfolgenden laseraktiven pn-Übergänge weniger als 2 µm.

Bei einer bevorzugten Ausführungsform sind die Quantenwells undotiert.

Die Erfindung wird im Folgenden anhand von zwei Ausführungsbeispielen in Verbindung mit der Figur näher erläutert. Die Figur zeigt eine schematische Schnitt-Darstellung eines Ausführungsbeispieles.

Der in der Figur dargestellte Aufbau einer kantenemittierenden Mehrfach-pn-Laserdiode weist ein Substrat 1 auf, das beispielsweise aus n-dotiertem GaAs besteht. An einer ersten Hauptfläche dieses Substrats 1 ist ein elektrischer Kontakt 2, z. B. ein n-Kontakt, aufgebracht, der beispielsweise aus GeNiAu gefertigt ist. Auf einer der ersten Hauptfläche gegenüberliegenden zweiten Hauptfläche des Substrats 1 ist eine erste Mantelschicht 3 angeordnet, die beispielsweise aus AlGaAs, insbesondere aus Al_{0.4}Ga_{0.6}As, besteht, eine Dotierung von n ≅ 5*10¹⁷ cm⁻³ und eine Dicke von 1 - 2 µm aufweist.

Auf der ersten Mantelschicht 3 ist eine aktive Schichtenfolge 4 angeordnet, die zwei Gruppen von bevorzugt undotierten Quantenwells 11, hier konkret jeweils zwei Quantenwells 11, enthalten und die von Barriereschichten 12 und Einfangschichten 13-15 eingeschlossen sind. Die Quantenwells bestehen z.B. aus undotiertem InGaAs (z. B. In_{0.2}Ga_{0.8}As-Quantenwells), die Barriereschichten 12 und Einfangschichten 13-15 bestehen z. B. aus GaAs bzw. Al_{0.2}Ga_{0.8}As.

Die Quantenwells 11 liegen jeweils in den Verarmungszonen von in Vorwärtsrichtung betriebenen pn-Dioden, jeweils bestehend aus zwei Quantenwells 11, zwei Barriereschichten 12, einer n-leitenden und einer p-leitenden Einfangschicht. Die zwischen den beiden Gruppen von Quantenwells 11 angeordnete Einfangschicht 14 ist als gegenüber den laseraktiven pn-Übergängen 8,9 rückwärtsgepolte hochdotierte Diode (z. B. n ≅ 5*10¹⁸ cm⁻³ und p ≅ 5*10¹⁹ cm⁻³) ausgebildet und weist einen größeren Bandabstand auf als die laseraktiven pn-Übergänge.

Auf der aktiven Schichtenfolge 4 ist eine zweite Mantelschicht 5 aufgebracht, die beispielsweise aus AlGaAs, insbesondere aus Al_{0.4}Ga_{0.6}As, besteht, eine Dotierung von p ≅ 5*10¹⁷ cm⁻³ und eine Dicke von 1 - 2 µm aufweist. Auf dieser Mantelschicht 5 befindet sich eine Kontaktschicht 6, auf der ein elektrischer Kontakt7, hier ein p-Kontakt aufgebracht ist. Die Kontaktschicht 6 besteht beispielsweise aus p⁺⁺-dotiertem GaAs und ist ca. 10 nm dick, und der p-Kontakt 7, besteht z. B. aus TiPtAu.

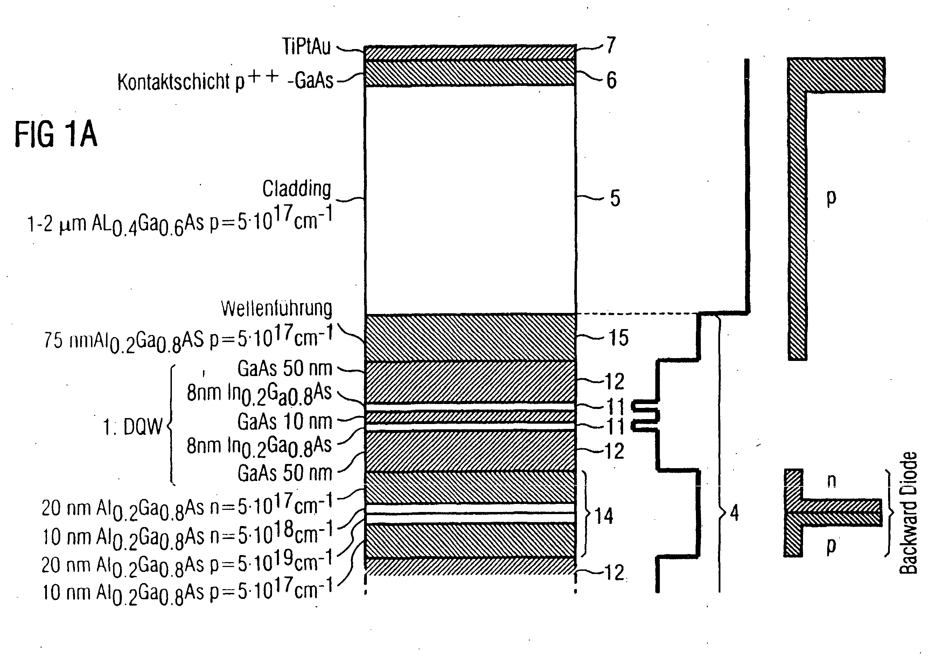

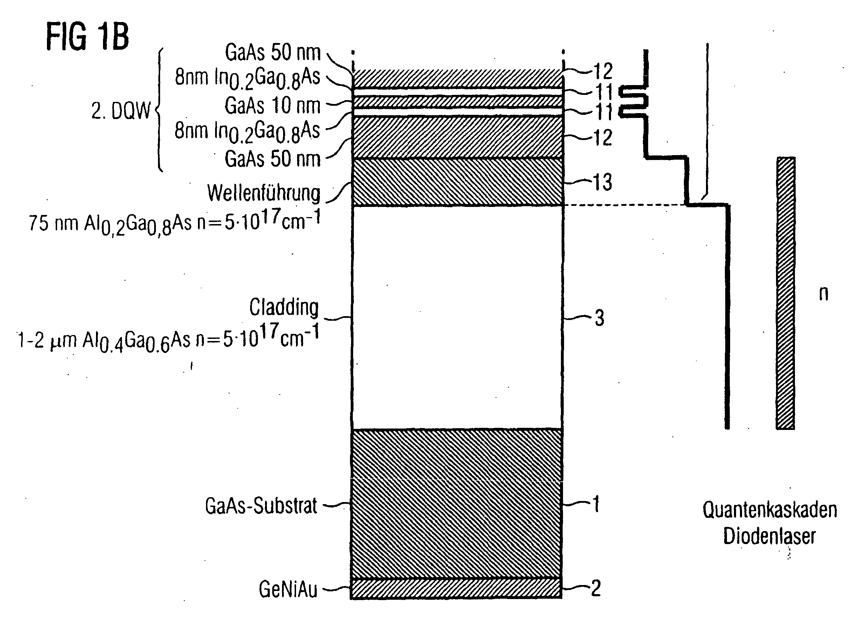

Die in Figur 1 dargestellte Struktur läßt sich unmittelbar als kantenemittierender Breitstreifenlaser herstellen. Sie lässt sich auch in kantenemittierenden transversal einmodigen Laserdioden verwenden, die zum Beispiel in Rippenwellenleiterstruktur zu realisieren sind.

Bei dem weiteren Ausführungsbeispiel handelt es sich um einen vertikal emittierenden Halbleiterlaser-Chip. Bei diesem sind an Stelle der beiden Mantelschichten 3,5 des Ausführungsbeispieles von Figur 1 in an sich bekannter Weise Bragg-Reflektorschichten, z. B. AlAs-GaAs-Bragg-Spiegel, verwendet.

Die Herstellung der oben beschriebenen Schichtenfolgen kann beispielsweise mittels Molekularstrahlepitaxie erfolgen. Zur p-Dotierung kann beispielsweise Kohlenstoff und zur n-Dotierung Silizium dienen. Die Herstellung ist auch mit metallorganischer Gasphasenepitaxie möglich.

Die erfindungsgemäße Struktur eines Halbleiterlaser-Chips führt zu einer Erhöhung des zu erzielenden Gewinns in der aktiven Schichtenfolge und damit zu einem Betrieb bei niedrigeren Schwellstromdichten. Dies ermöglicht das Design höchst effizienter Large Optical Cavity Strukturen.

Die erfindungsgemäße Struktur ist nicht auf das InAlGaAs-Halbleitersystem beschränkt, sondern läßt sich beispielsweise auch in den Materialsystemen InAlGaAsP auf InP-Substrat oder auch im InAlGaNAs-System verwirklichen. Auch in II-VI-Halbleitersystemen, wie z. B. ZnMgBeSSe ist die Laserstruktur zu realisieren.

## Patentansprüche

1. Kantenemittierender Halbleiterlaser-Chip, bei dem in einem optischen Resonator eine laseraktive Halbleiterstruktur angeordnet ist, wobei
in ein und demselben Resonator des Halbleiterlaser-Chips zwei oder mehrere in Serie geschaltete laseraktive pn-Übergänge eingebracht sind, deren Vorwärtsrichtungen gleichgerichtet sind,
die laseraktiven pn-Übergänge Quantenwells (11) für die Ladungsträgerrekombination enthalten,
zwischen zwei laseraktiven pn-Übergängen jeweils ein pn-Übergang angeordnet ist, dessen Vorwärtsrichtung der Vorwärtsrichtung der laseraktiven pn-Übergänge entgegengerichtet ist,
dieser rückwärtsgepolte pn-Übergang sich in Halbleitermaterial mit einem größeren Bandabstand als der des Halbleitermaterials der laseraktiven pn-Übergänge befindet und
sich die laseraktiven pn-Übergänge in einer wellenführenden Zone befinden.

2. Vertikalemittierender Halbleiterlaser-Chip, bei dem in einem optischen Resonator eine laseraktive Halbleiterstruktur angeordnet ist, wobei
in ein und demselben Resonator des Halbleiterlaser-Chips zwei oder mehrere in Serie geschaltete laseraktive pn-Übergänge eingebracht sind, deren Vorwärtsrichtungen gleichgerichtet sind,
die laseraktiven pn-Übergänge Quantenwells (11) für die Ladungsträgerrekombination enthalten,
zwischen zwei laseraktiven pn-Übergängen jeweils ein pn-Übergang angeordnet ist, dessen Vorwärtsrichtung der Vorwärtsrichtung der laseraktiven pn-Übergänge entgegengerichtet ist,
dieser rückwärtsgepolte pn-Übergang sich in Halbleitermaterial mit einem größeren Bandabstand als der des Halbleitermaterials der laseraktiven pn-Übergänge befindet und
sich die Quantenwells der laseraktiven pn-Übergänge in den Bäuchen und der rückwärtsgepolte pn-Übergang bzw. die rückwärtsgepolten pn-Übergänge im bzw. in den Knoten des in dem Halbleiterlaser-Chip erzeugten Stehwellenfeldes befinden.

## Claims

1. Edge emitting semiconductor laser chip in which a laser-active semiconductor structure is arranged in an optical resonator, in which case
two or more series-connected laser-active pn junctions whose forward directions are unidirectional are introduced in one and the same resonator of the semiconductor laser chip,
the laser-active pn junctions contain quantum wells (11) for the charge carrier recombination,
a pn junction whose forward direction is directed oppositely to the forward direction of the laser-active pn junctions is in each case arranged between two laser-active pn junctions,
this reverse-biased pn junction is situated in semiconductor material having a band gap greater than that of the semiconductor material of the laser-active pn junctions, and
the laser-active pn junctions are situated in a wave-guiding zone.

2. Vertically emitting semiconductor laser chip in which a laser-active semiconductor structure is arranged in an optical resonator, in which case two or more series-connected laser-active pn junctions whose forward directions are unidirectional are introduced in one and the same resonator of the semiconductor laser chip,
the laser-active pn junctions contain quantum wells (11) for the charge carrier recombination,
a pn junction whose forward direction is directed oppositely to the forward direction of the laser-active pn junctions is in each case arranged between two laser-active pn junctions,
this reverse-biased pn junction is situated in semiconductor material having a band gap greater than that of the semiconductor material of the laser-active pn junctions, and
the quantum wells of the laser-active pn junctions are situated in the antinodes and the reverse-biased pn junction or the reverse-biased pn junctions is or are situated in the node or nodes of the standing wave field generated in the semiconductor laser chip.

## Revendications

1. Puce de laser à semiconducteur à émission sur la limite de bande, dans laquelle une structure à semiconducteur à activité laser est disposée dans un résonateur optique, dans laquelle
il est mis dans un seul et même résonateur de la puce de laser à semiconducteur deux jonctions pn à activité laser ou plusieurs jonctions pn à activité laser montées en série, dont les sens directs ont le même sens,
les jonctions pn à activité laser comportent des puits (11) quantiques pour la recombinaison de porteurs de charge,
il est interposé entre deux jonctions pn à activité laser respectivement une jonction pn, dont le sens direct est opposé au sens direct des jonctions pn à activité laser,
cette jonction pn polarisée en inverse se trouve dans du matériau semiconducteur en ayant une bande interdite plus grande que celle du matériau semiconducteur des jonctions pn à activité laser, et
les jonctions pn à activité laser se trouvent dans une zone de guide d'onde.

2. Puce de laser à semiconducteur à émission verticale, dans laquelle
il est disposé une structure à semi-conducteur à activité laser dans un résonateur optique,
il est mis dans un seul et même résonateur de la puce de laser à semiconducteur deux jonctions pn à activité laser ou plusieurs jonctions pn à activité laser montées en série, dont les sens directs ont le même sens,
les jonctions pn à activité laser comportent des puits (11) quantiques pour la recombinaison de porteurs de charge,
il est interposé entre deux jonctions pn à activité laser respectivement une jonction pn, dont le sens direct est opposé au sens direct des jonctions pn à activité laser,
cette jonction pn polarisée en inverse se trouve dans du matériau semiconducteur ayant une bande interdite plus grande que celle du matériau semiconducteur des jonctions pn à activité laser, et
les puits quantiques des jonctions pn à activité laser se trouvent dans les ventres et la jonction pn polarisée en inverse ou les jonctions pn polarisées en inverse se trouvent dans le ou dans les noeuds du champ d'onde stationnaire produit dans la puce de laser à semiconducteur.
